# EUROPEAN PATENT SPECIFICATION

(11) **EP 3 072 238 B1**
(45) Date of publication and mention of the grant of the patent: **13.03.2019**
(21) Application number: 14803305.3
(22) Date of filing: 10.11.2014
(51) Int. Cl.: H03K 19/00, G06F 13/38, H03K 19/0175

(54) **DEVICES AND METHODS FOR FACILITATING DATA INVERSION TO LIMIT BOTH INSTANTANEOUS CURRENT AND SIGNAL TRANSITIONS**
VORRICHTUNGEN UND VERFAHREN ZUR DATENINVERSION ZUR BEGRENZUNG VON SOWOHL MOMENTANEN STROM- ALS AUCH SIGNALÜBERGÄNGEN
DISPOSITIFS ET PROCÉDÉS POUR FACILITER L'INVERSION DE DONNÉES AFIN DE LIMITER À LA FOIS UN COURANT INSTANTANÉ ET DES TRANSITIONS DE SIGNAUX

(30) Priority: 21.11.2013 US 201314086858
(43) Date of publication of application: 28.09.2016
(73) Proprietor: Qualcomm Incorporated, San Diego, CA 92121-1714 (US)
(72) Inventor: HOLLIS, Timothy Mowry, San Diego, California 92121-1714 (US)
(74) Representative: Schmidbauer, Andreas Konrad
(86) International application number: PCT/US2014/064760
(87) International publication number: WO 2015/077066

(56) References cited:
- US-A- 5 931 927
- US-A1- 2004 225 945
- US-A1- 2010 045 491
- US-A1- 2011 222 623
- US-A1- 2013 287 311
- SUMANT RAMPRASAD ET AL: "A Coding Framework for Low-Power Address and Data Busses", IEEE TRANSACTIONS ON VERY LARGE SCALE INTEGRATION (VLSI) SYSTEMS, IEEE SERVICE CENTER, PISCATAWAY, NJ, USA, vol. 7, no. 2, 1 June 1999 (1999-06-01), XP011063428, ISSN: 1063-8210

## Description

### CROSS-REFERENCE TO RELATED APPLICATIONS

This application claims priority to and the benefit of U.S. non-provisional patent application no. 14/086,858 filed in the United States Patent and Trademark Office on November 21, 2013.

### TECHNICAL FIELD

The technology discussed below relates generally to electronic devices including a data bus, and more specifically to methods and devices for encoding data bits for transmission over a data bus and decoding data bits transmitted over a data bus.

### BACKGROUND

Data transmission across interconnects may take a number of forms. One example of a configuration for facilitating data transmission between components is use of a data bus, where a transmitting component sends data signals, also called data bits, to a receiving component over a group of parallel transmission channels. The data bits are typically subject to inter-symbol interference (ISI), crosstalk, and simultaneous switching noise (SSN) that can alter the amplitude and timing of the data bits. Often, the data bits may be encoded to reduce the effects of ISI, crosstalk, and/or SSN using various techniques of data encoding. One specific form of data encoding is Data Bus Inversion (DBI). In the prior art patent application US2004225945 A1 discloses alternative schemes for the encoding for data transmission between electronic modules.

### BRIEF SUMMARY OF SOME EXAMPLES

The following summarizes some aspects of the present disclosure to provide a basic understanding of the discussed technology. This summary is not an extensive overview of all contemplated features of the disclosure, and is intended neither to identify key or critical elements of all aspects of the disclosure nor to delineate the scope of any or all aspects of the disclosure. Its sole purpose is to present some concepts of one or more aspects of the disclosure in summary form as a prelude to the more detailed description that is presented later. The invention is described by the contents of the independent claims.

Various examples and implementations of the present disclosure facilitate data encoding utilizing a plurality of encoding techniques on each data channel of a data bus. According to at least one aspect of the disclosure, electronic devices may include an encoder with a data bus interface and a processing circuit communicatively and/or operationally coupled together. The data bus interface can be coupled with a data bus to facilitate a transmission of data bits. The processing circuit may be adapted to perform a first encoding scheme on a group of data bits to be transmitted on a data bus via the data bus interface, where the first encoding scheme is performed based on a number of transitions within the group of data bits. The processing circuit may further be adapted to perform a second encoding scheme on the group of data bits based on a number of data bits within the group of data bits exhibiting a predetermined state. The processing circuit can also be adapted to set a plurality of first encoding flags to indicate which data bits are encoded by the first encoding scheme, and set a plurality of second encoding flags to indicate which data bits are encoded by the second encoding scheme.

Further aspects provide methods operational on electronic devices and/or electronic devices including means to perform such methods. One or more examples of such methods may include performing a first encoding scheme on a group of data bits to be transmitted over a data bus. The first encoding scheme may be performed based on a number of transitions within the group of data bits. A second encoding scheme may also be performed on the group of data bits. The second encoding scheme may be performed based on a number of data bits within the group of data bits exhibiting a predetermined state. Additionally, first encoding flags may be set to indicate which data bits are encoded by the first encoding scheme, and second encoding flags may be set to indicate which data bits are encoded by the second encoding scheme.

Still further aspects include processor-readable storage mediums comprising programming operational on a processing device, such as an electronic device. According to one or more examples, such programming may be adapted for causing a processing circuit to employ a first encoding scheme on a group of data bits to be transmitted over a data bus. The first encoding scheme may be performed based on a number of transitions within the group of data bits. The programming may further be adapted for causing a processing circuit to employ a second encoding scheme on the group of data bits. The second encoding scheme may be performed based on a number of data bits within the group of data bits exhibiting a predetermined state.

Additional aspects of the present disclosure provide electronic devices including at least one encoder. Such an encoder may include a transition detector, a state detector, and an invertor. The transition detector may be adapted to determine a number of transitions on a plurality of data channels of a data bus for a predetermined number of cycles. The state detector may be adapted to determine a number of cycles set to a predetermined state on each data channel of the plurality of data channels for the predetermined number of cycles. The invertor may be adapted to invert every other cycle of the predetermined number of cycles on a data channel when the number of transitions on the data channel is determined to be above a transition threshold. The invertor may further be adapted to invert the cycles of the predetermined number of cycles on a data channel when the number of cycles set to the predetermined state on the data channel is determined to be above a state threshold.

Further aspects provide methods operational on electronic devices and/or electronic devices including means to perform such methods. One or more examples of such methods may include determining a number of transitions on a plurality of data channels of a data bus for a predetermined number of cycles. When the number of transitions on a data channel is determined to be above a transition threshold, every other cycle of the data channel may be inverted. A respective transition inversion encoding flag associated with each data channel may be set to indicate whether every other cycle of the associated data channel has been inverted. A determination may also be made of the number of cycles set to a predetermined state on each data channel of the plurality of data channels for the predetermined number of cycles. When the number of cycles set to the predetermined state on a data channel is above a state threshold, the cycles of the data channel may be inverted. A respective state inversion encoding flag associated with each data channel may be set to indicate whether the cycles of the associated data channel are inverted.

Still further aspects include processor-readable storage mediums comprising programming operational on a processing device, such as an electronic device. According to one or more examples, such programming may be adapted for causing a processing circuit to determine a number of transitions on a plurality of data channels of a data bus for a predetermined number of cycles, invert every other cycle of a data channel when the number of transitions on the data channel is determined to be above a transition threshold, and set a respective transition inversion encoding flag associated with each data channel to indicate whether every other cycle of the associated data channel has been inverted. The programming may further be adapted for causing a processing circuit to determine a number of cycles set to a predetermined state on each data channel of the plurality of data channels for the predetermined number of cycles, invert the cycles of a data channel when the number of cycles set to the predetermined state on the data channel is above a state threshold, and set a respective state inversion encoding flag associated with each data channel to indicate whether the cycles of the associated data channel are inverted.

Various examples and implementations of the present disclosure further facilitate decoding data that has been encoded utilizing a plurality of encoding techniques on each data channel of a data bus. According to at least one aspect of the disclosure, electronic devices may include a decoder with a data bus interface and an invertor communicatively and/or operationally coupled together. The data bus interface can be coupled with a data bus to facilitate reception of data bits. The invertor may be adapted to receive a group of data bits on a plurality of data channels via the data bus interface. The invertor may decode the group of data bits for a first encoding scheme, and then decode the group of data bits for a second encoding scheme.

Additional aspects provide methods operational on electronic devices and/or electronic devices including means to perform such methods. One or more examples of such methods may include receiving a group of data bits on a plurality of data channels of a data bus. The group of data bits may be decoded for a first encoding scheme, and then decoded for a second encoding scheme.

Still further aspects include processor-readable storage mediums comprising programming operational on a processing device, such as an electronic device. According to one or more examples, such programming may be adapted for causing a processing circuit to decode a group of received data bits for a first encoding scheme, and then decode the group of data bits for a second encoding scheme.

Other aspects, features, and embodiments associated with the present disclosure will become apparent to those of ordinary skill in the art upon reviewing the following description in conjunction with the accompanying figures.

### DRAWINGS

FIG. 1 is a block diagram of a system environment in which one or more aspects of the present disclosure may find application.
FIG. 2 is a block diagram illustrating an example of data bits transmitted over different channels of a data bus.
FIG. 3 is a block diagram illustrating an example of DBI AC encoding applied to the data bits of FIG. 2.
FIG. 4 is a block diagram illustrating an example of DBI DC encoding applied to the data bits of FIG. 2.
FIG. 5 is a block diagram illustrating select components of an electronic device and decoder according to at least one example.
FIG. 6 is a block diagram illustrating an example of data encoding according to at least one example of the present disclosure.
FIG. 7 is a block diagram illustrating another example of data encoding according to at least one example in which encoding flags are transmitted on the original data channels as additional data bits appended to the end of the group of data bits.
FIG. 8 is a block diagram illustrating another example of data encoding according to at least one example in which one set of encoding flags are transmitted on an additional channel and the other set of encoding flags are transmitted as additional data bits appended to the end of the group of data bits.
FIG. 9 is a block diagram illustrating another example of data encoding according to at least one example in which encoding flags are sent on an additional channel, where a plurality of consecutive cycles of the additional channel are associated with a respective data channel.
FIG. 10 is a block diagram illustrating another example of data encoding according to at least one example in which transition encoding flags and state encoding flags are sent on the same additional channel.
FIG. 11 is a flow diagram illustrating a method operational on an electronic device according to at least one example.
FIG. 12 is a flow diagram illustrating an example of a process for performing the first encoding scheme of FIG. 11 based on the number of transitions according to at least one implementation.
FIG. 13 is a flow diagram illustrating an example of a process for performing the second encoding scheme of FIG. 11 based on the number of cycles having a particular state according to at least one implementation.
FIG. 14 is a block diagram illustrating select components of an electronic device according to at least one example.
FIG. 15 is a flow diagram illustrating a decoding method operational on an electronic device according to at least one example.

### DETAILED DESCRIPTION

The description set forth below in connection with the appended drawings is intended as a description of various configurations and is not intended to represent the only configurations in which the concepts and features described herein may be practiced. The following description includes specific details for the purpose of providing a thorough understanding of various concepts. However, it will be apparent to those skilled in the art that these concepts may be practiced without these specific details. In some instances, well known circuits, structures, techniques and components are shown in block diagram form to avoid obscuring the described concepts and features.

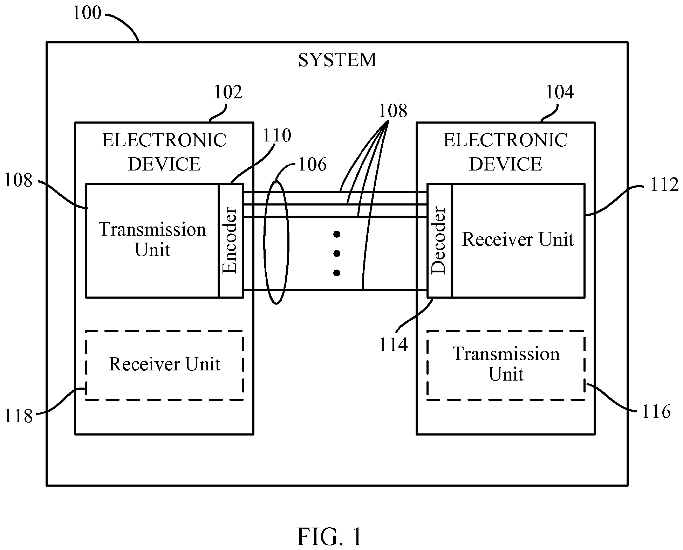

Referring now to FIG. 1, a block diagram is shown illustrating an example of a system environment in which one or more aspects of the present disclosure may find application. The system 100 includes a first electronic device 102 and a second electronic device 104 communicatively coupled to each other by a parallel data bus 106. The first electronic device 102 is shown as a transmitter (or the transmitting device) and includes a transmission unit 108 with an encoder 110 and adapted to send encoded data bits from the first electronic device 102 to the second electronic device 104 over the data bus 106. The second electronic device 104 accordingly includes a receiver unit 112 with a decoder 114 for receiving and decoding the encoded data bits. In some examples, the data bus 106 may be a unidirectional bus. In other examples, the data bus 106 may be a bidirectional bus, in which case the second electronic device 104 may also include a transmission unit 116 adapted to send data bits over the data bus 106 to the receiver unit 118 of the first electronic device 102.

The first and second electronic devices 102, 104 may be any devices that can communicate using single-ended signaling. In various examples, the first and second electronic devices 102, 104 may be components in a computer system. For example, the electronic device 102 may be a processing unit, the second electronic device 104 may be a memory module, and the data bus 104 may be a system bus. In at least one example, a memory controller interface (e.g., a physical memory interface circuit PHY) of the processor and a memory module may include respective transmission and receiver units to perform write and read operations. The processor may be any suitable type of processing unit, such as a central processing unit (CPU), a co-processor, an arithmetic processing unit, a graphics processing unit (GPU), a digital signal processor (DSP), etc. The memory module may also be any suitable type of memory. In some examples, the second electronic device 104 may be another type of device, such as a bridge controller, a storage device (e.g., hard drive, optical drive, flash drive, storage array, etc.), a network interface device (e.g., to a local or wide-area network), a user interface device (e.g., display device, sound device, printer), etc. In some examples, the first and second electronic devices 102, 104 may be separate cores within a processing unit or separate processing units in a system. Accordingly, in at least one example, the system 100 may be a communication network, where the first and second electronic devices 102, 104 may be routers, switches, end devices, etc. Thus, in general, the first and second electronic devices 102, 104 may be any suitable devices adapted to send and/or receive data bits over a data bus 106.

The data bus 106 may include approximately parallel conductive traces or lines that may be referred to as channels 108, and these channels 108 can be coupled at each end to respective pins in the electronic devices 102 and 104. The number of channels 108 of the data bus 106 may vary according to different embodiments. By way of example only, the data bus 106 may include 4, 8, 16, 32, 64, 72, etc. data channels 108, as well as additional channels 108 to transmit control signals in parallel with the data bits. For example, a data bus 106 may have 72 data channels and 8 control channels for a total of 80 channels 108. The data bus may additionally support an accompanying clocking topology.

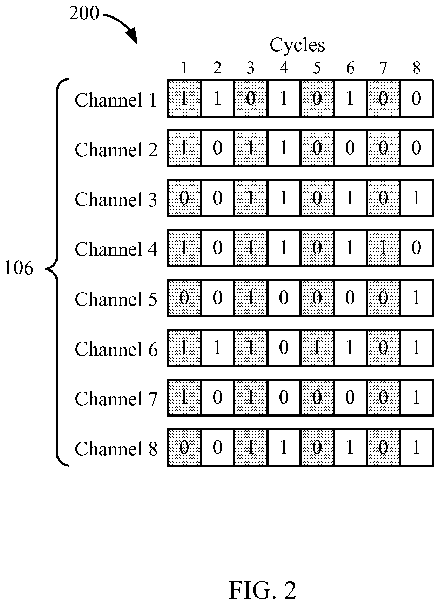

The data bits transmitted over the channels 108 are binary data bits including ones (Is) and zeros (0s), or high and low voltages. FIG. 2 is a block diagram 200 illustrating an example of data bits transmitted over different channels of a data bus 106. As illustrated, each row represents a separate data channel, with eight data bits or cycles shown as transmitted on each channel. The odd-numbered cycles or bits are shaded simply to facilitate easier viewing.

As the data bits are transmitted over the data bus 106, the data bits are typically subject to inter-symbol interference (ISI), crosstalk, and simultaneous switching noise (SSN) that can alter the amplitude and timing of the data bits. Often, the data bits may be encoded to reduce the effects of ISI, crosstalk, and/or SSN using various techniques of data encoding. One specific form of data encoding is often referred to as Data Bus Inversion (DBI).

Data bus inversion is a feature that employs circuitry to look at the relationship between bits to be transmitted, and then decide if it would be advantageous to invert some or all of the bits prior to transmission. If the bits are inverted, an additional signal is also set to indicate that the bits are inverted. This additional signal is often referred to as a data bus inversion (DBI) flag or an encoding flag. An extra channel can be used so the DBI flag can be sent in parallel with the other bits to identify to the receiving circuitry which sets of data have been inverted. The receiver uses the DBI flag to return the incoming data to its original state.

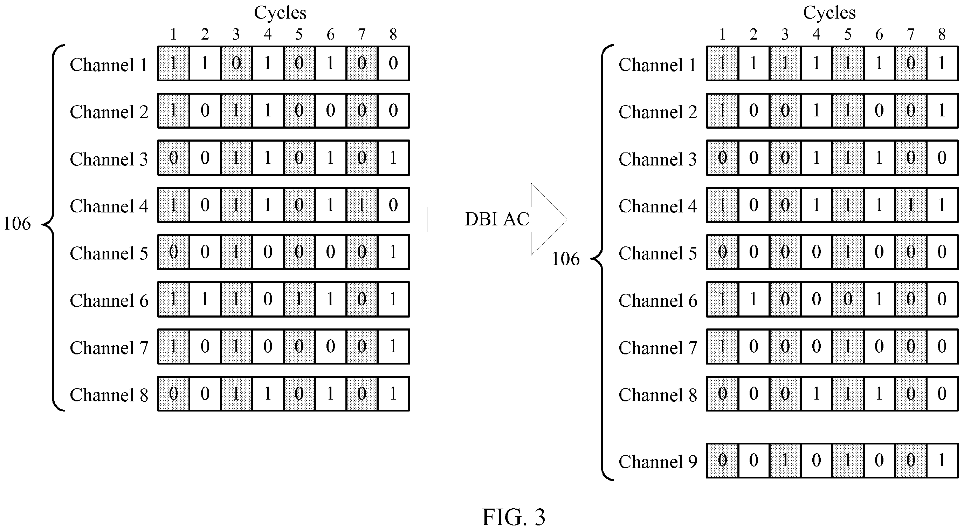

There are generally two types of data bus inversion techniques used for DBI encoding. The first technique, which may be referred to by those of skill in the art as DBI AC or minimum transitions, is used to reduce the number of transitions on a data channel (e.g., changes from a zero to a one, or from one to zero) to improve AC power and reduce issues from crosstalk, etc. FIG. 3 is a block diagram illustrating an example of conventional DBI AC encoding. On the left is the raw data from FIG. 2, and the right-side shows the resulting encoded data. DBI AC encoding is typically employed to reduce the number of simultaneous transitions. In the raw data, there are a total of 34 transitions through the eight cycles on all eight channels of the data bus 106. As shown, when a device determines that the data scheduled for transmission on more than half of the data channels have a transition from one cycle to the next, then the device can invert the next cycle on all the data channels. For instance, from cycle 2 to cycle 3, seven of the eight data channels have a transition, either from a one to a zero or from a zero to a one. Accordingly, the device can invert cycle 3, so that only one of the eight data channels will have a transition. Additionally, a DBI flag is set at cycle 3 on the DBI control channel identified as channel 9 in FIG. 3. In this example, the number of transitions in the data transmitted on the data bus 106 decreases from 34 to 25, but the number of ones (e.g., logic HIGH signals) transmitted on the data bus 106 increases from 31 to 32.

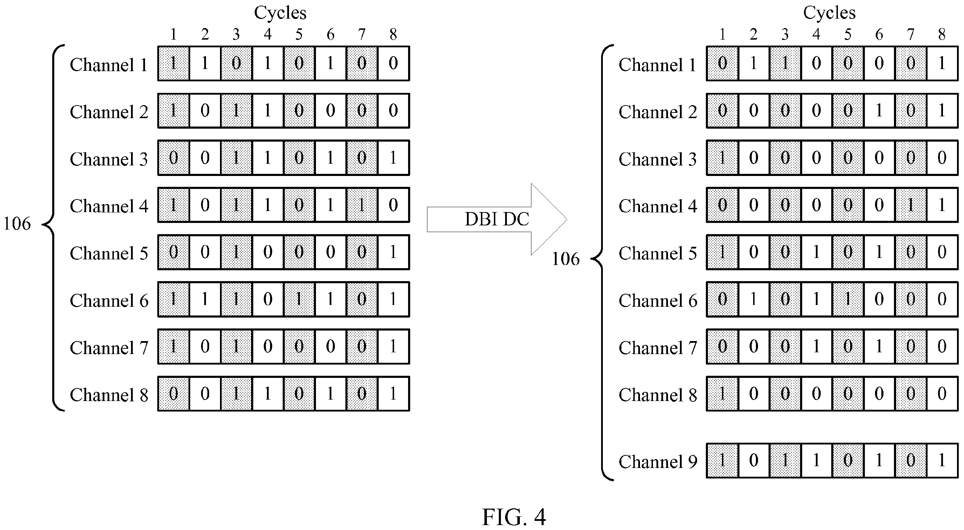

The second technique for data bus inversion, which may be referred to as DBI DC, minimum ones, or minimum zeros, is used to reduce the number of data bits of a particular state (e.g., reduce the number of ones or the number of zeros). FIG. 4 is a block diagram illustrating an example of conventional DBI DC encoding. Once again, the diagram on the left is the raw data from FIG. 2 and the diagram on the right illustrates the resulting encoded data. DBI DC encoding is typically employed to reduce the number of data bits having a particular state. For instance, in this example the DBI DC is employed to reduce number of ones (or logical HIGH signals) transmitted on the data bus 106. As shown, when a device determines that more than half of the data channels have a logical HIGH signal (a one) on a given cycle, then the device can invert the cycle for all data channels. For instance, cycle 1 in the raw data has logical HIGH signals (ones) on five of the eight data channels. Accordingly, the device can invert cycle 1 on each of the data channels so that only three of the eight data channels will transmit a logical HIGH signal (a one). Additionally, a DBI flag is set at cycle 1 on the DBI control channel identified as channel 9 in FIG. 4. In this example, the number of ones (e.g., logical HIGH signals) transmitted on the data bus 106 is reduced from 31 to 22. The number of transitions also decreases from 34 to 28 in this example, although this example is not typical for this technique. Generally, this technique results in an increase in the number of transitions.

These described DBI techniques are generally able to optimize one aspect, but at the expense of the other aspect. For example, reduction in transitions typically results in increased ones (e.g., logical HIGH signals). Similarly, reduction in ones (e.g., logical HIGH signals) typically results in an increase to the number of transitions. DBI techniques have been unable to optimize both the number of transitions and the number of cycles having a particular state (e.g., the number of 1s or 0s).

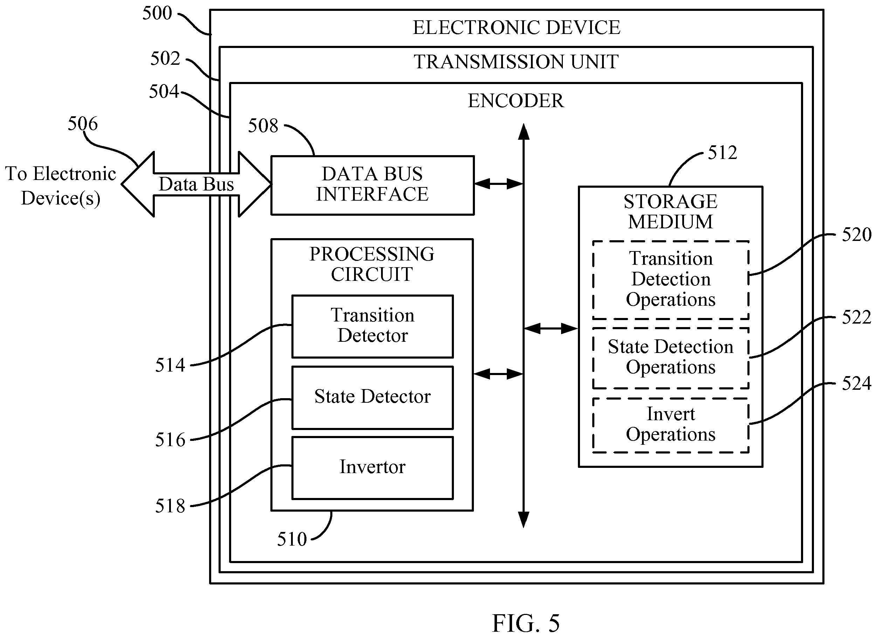

According to at least one aspect of the present disclosure, electronic systems include one or more electronic devices adapted to employ data encoding techniques capable of facilitating a reduction to the number of transitions and the number of bits having a particular state (e.g., either one or zero). Turning to FIG. 5, a block diagram is shown illustrating select components of an electronic device 500, such as the first or second electronic device 102, 104 from FIG. 1 according to at least one example of the present disclosure. A transmission unit 502 of the electronic device 500 includes an encoder 504 adapted to transmit data bits over a plurality of channels of a data bus 506.

The encoder 504 generally includes circuitry and/or programming adapted to perform a first encoding scheme to a plurality of data bits based on a number of transitions in the data bits, and perform a second encoding scheme to the same plurality of data bits based on a number of data bits having a predetermined state (e.g., a one or a zero). According to at least one example, the encoder 504 may be coupled to a plurality of data channels of the data bus 506 by a data bus interface 508, and may include a processing circuit 510 coupled to or placed in electrical communication with the data bus interface 508 and a storage medium 512.

The processing circuit 510 is arranged to obtain, process and/or send data, control data access and storage, issue commands, and control other desired operations. The processing circuit 510 may include circuitry adapted to implement desired programming provided by appropriate media in at least one example. In some instances, the processing circuit 510 may include circuitry adapted to perform a desired function, with or without implementing programming. By way of example, the processing circuit 510 may be implemented as one or more processors, one or more controllers, and/or other structure configured to execute executable programming and/or perform a desired function. Examples of the processing circuit 510 may include a general purpose processor, a digital signal processor (DSP), an application specific integrated circuit (ASIC), a field programmable gate array (FPGA) or other programmable logic component, discrete gate or transistor logic, discrete hardware components, or any combination thereof designed to perform the functions described herein. A general purpose processor may include a microprocessor, as well as any conventional processor, controller, microcontroller, or state machine. The processing circuit 510 may also be implemented as a combination of computing components, such as a combination of a DSP and a microprocessor, a number of microprocessors, one or more microprocessors in conjunction with a DSP core, an ASIC and a microprocessor, or any other number of varying configurations. These examples of the processing circuit 510 are for illustration and other suitable configurations within the scope of the present disclosure are also contemplated.

The processing circuit 510 is adapted for processing, including the execution of programming, which may be stored on the storage medium 512. As used herein, the term "programming" shall be construed broadly to include without limitation instructions, instruction sets, code, code segments, program code, programs, subprograms, software modules, applications, software applications, software packages, routines, subroutines, objects, executables, threads of execution, procedures, functions, etc., whether referred to as software, firmware, middleware, microcode, hardware description language, or otherwise.

In some instances, the processing circuit 510 may include a transition detector 514, a state detector 516, and an invertor 518. The transition detector 514 may include circuitry and/or programming (e.g., the transition detection operations 520 stored on the storage medium 512) adapted to evaluate a group of data bits (e.g., predetermined number of consecutive data bits prepared for transmission on a common data channel) to determine how many transitions will occur. The state detector 516 may include circuitry and/or programming (e.g., the state detection operations 522 stored on the storage medium 512) adapted to evaluate the same group of data bits to determine how many data bits exhibit a predetermined state (e.g., a one or a zero). Further, the invertor 518 may include circuitry and/or programming (e.g., the invert operations 524 stored on the storage medium 512) adapted to invert at least some of the data bits within the group of data bits when the number of transitions is determined by the transition detector 514 to be above a transition threshold, and to invert the group of data bits when the number of data bits exhibiting the predetermined state is determined by the state detector 516 to be above a state threshold. The invertor 518 can further provide a transition flag (e.g., a transition DBI flag, or transition encoding flag) to indicate whether the group of data bits has been inverted for transitions and a state flag (e.g., a state DBI flag, or state encoding flag) to indicate whether the group of data bits has been inverted for ones or zeros.

The storage medium 512 may represent one or more processor-readable devices for storing programming, electronic data, databases, or other digital information. The storage medium 512 may also be used for storing data that is manipulated by the processing circuit 510 when executing programming. The storage medium 512 may be any available media that can be accessed by the processing circuit 510, including portable or fixed storage devices, optical storage devices, and various other mediums capable of storing, containing and/or carrying programming. By way of example and not limitation, the storage medium 512 may include a processor-readable storage medium such as a magnetic storage device (e.g., hard disk, floppy disk, magnetic strip), an optical storage medium (e.g., compact disk (CD), digital versatile disk (DVD)), a smart card, a flash memory device (e.g., card, stick, key drive), random access memory (RAM), read only memory (ROM), programmable ROM (PROM), erasable PROM (EPROM), electrically erasable PROM (EEPROM), a register, a removable disk, and/or other mediums for storing programming, as well as any combination thereof.

The storage medium 512 may be coupled to the processing circuit 510 such that the processing circuit 510 can read information from, and write information to, the storage medium 512. That is, the storage medium 512 can be coupled to the processing circuit 510 so that the storage medium 512 is at least accessible by the processing circuit 510, including examples where the storage medium 512 is integral to the processing circuit 510 and/or examples where the storage medium 512 is separate from the processing circuit 510.

Programming stored by the storage medium 512, when executed by the processing circuit 510, causes the processing circuit 510 to perform one or more of the various functions and/or process steps described herein. For example, the storage medium 512 may include transition detection operations 520, state detection operations 522, and invert operations 524. Thus, according to one or more aspects of the present disclosure, the processing circuit 510 is adapted to perform (in conjunction with the storage medium 512) any or all of the processes, functions, steps and/or routines for any or all of the electronic devices described herein (e.g., first electronic device 102, second electronic device 104, electronic device 500). As used herein, the term "adapted" in relation to the processing circuit 510 may refer to the processing circuit 510 being one or more of configured, employed, implemented, and/or programmed (in conjunction with the storage medium 512) to perform a particular process, function, step and/or routine according to various features described herein.

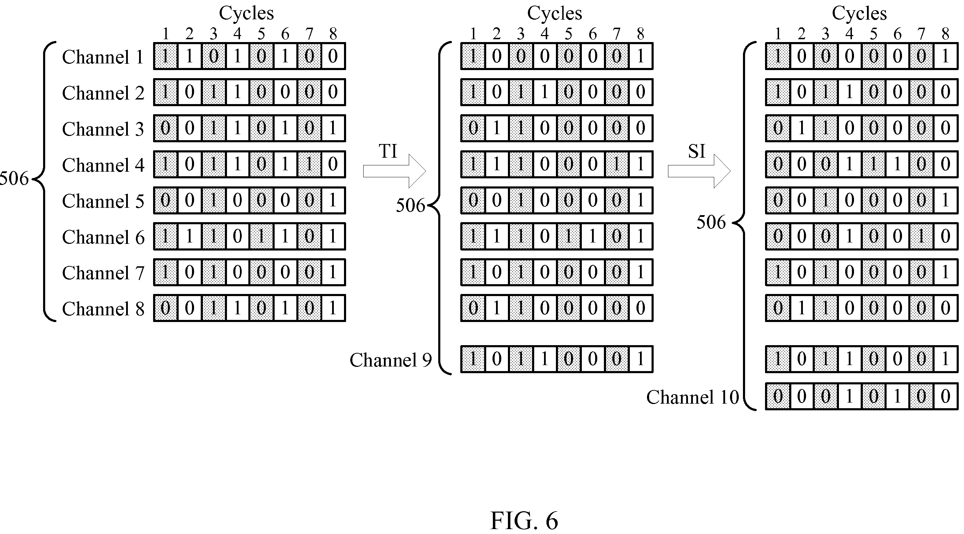

In operation, the encoder 504 is adapted to employ data encoding techniques capable of facilitating a reduction to the number of transitions by employing transition inversion encoding, and the number of bits having a particular state (e.g., either one or zero) by employing state inversion encoding. In one example, the encoder 504 can perform transition inversion encoding on each channel, followed by state inversion encoding on each channel. FIG. 6 is a block diagram illustrating such an example. On the left is the raw data from FIG. 2. The middle shows the group of data bits after transition inversion (TI) encoding, and the right-side shows the encoded group of data bits following state inversion encoding.

As noted, the encoder 504 (e.g., the transition detector 514) can initially determine how many data cycles represent transitions on each data channel for a group of data bits including a predetermined number of cycles. In this example, the predetermined number of cycles is shown as eight cycles or data bits, although the specific number may vary as desired. If the number of transitions over the predetermined number of cycles is determined to be more than half (½) the number of total cycles (e.g., more than 4 transitions over 8 cycles), then the encoder 504 (e.g., the invertor 518) can invert every other bit in the group of data bits for that data channel.

More specifically, the data bits on each data channel is evaluated to determine the number of transitions over the eight cycles. In the depicted example, the first data channel (channel 1) shows five (5) transitions over the eight cycles. Because this is larger than 4 (i.e., half the number of cycles), the encoder 504 can invert every other cycle on the data channel (channel 1). In this example, bits 2, 4, 6, and 8 are inverted, although other examples may invert bits 1, 3, 5, and 7. By inverting every other bit as shown, the data channel (channel 1) has only two transitions, as shown in the middle column for channel 1. To indicate that an inversion has occurred on the first data channel, the encoder 504 (e.g., the invertor 518) is adapted to set an encoding flag (or TI encoding flag) to be transmitted. In this example, the TI encoding flag is set on the first bit of the flag channel (e.g., the first bit on channel 9 is set to a one or logic HIGH signal). In this example, the bit number of the flag channel (channel 9) corresponds to a specific data channel.

The encoder 504 further evaluates each of the remaining data channels (e.g., channels 2 through 8) for transitions over the eight-bit group. In this example, channels 3, 4, and 8 are also partially inverted (e.g., every other bit is inverted) in a manner similar to channel 1. Further, the corresponding bits 3, 4, and 8 of the flag channel (channel 9) are also set to transmit a TI encoding flag. As shown in the middle column in FIG. 6, the result of this first step is a reduction in the number of transitions across the group of data bits from 34 in the original group of data bits to 26 in the encoded group of data bits in the middle column.

With the transition inversion encoding completed, the encoder 504 (e.g., the state detector 516) can evaluate the data bits on each data channel resulting from the transition inversion encoding to determine how many data bits exhibit a predefined state (e.g. a one or a zero). In this example, the encoder 504 can evaluate each data channel to determine how many ones (e.g., logic HIGH signals) occur for the encoded group of data bits. If the number of ones in the encoded data bits for each data channel is more than half (½) the number of total cycles (e.g., more than 4 data bits with a one or logic HIGH signal over 8 cycles), then the encoder 504 (e.g., invertor 518) can invert all the bits on that data channel.

More specifically, the encoder 504 can evaluate each of the transition inversion encoded data channels. In the example in FIG. 6, the fourth data channel (channel 4) has five (5) data bits set to one (e.g., with a logic HIGH signal) in the middle column. That is, data bits 1, 2, 3, 7, and 8 on channel 4 are all set to a one after the transition inversion encoding (as shown in the middle column). Accordingly, the encoder 504 can invert all of the data bits in the fourth data channel (e.g., channel 4), reducing the number of data bits set to a one (e.g., a logic HIGH signal) from five to three for that data channel. As shown, the sixth data channel (channel 6) can be similarly inverted. To indicate that an inversion has occurred for the state inversion (SI) encoding on data channels 4 and 6, a second flag channel (channel 10) is used in a manner similar to the first flag channel (channel 9). Thus, the encoder 504 will set data bits 4 and 6 on the second flag channel (channel 10) to a logic HIGH signal (a one) to indicate that the corresponding data channels 4 and 6 have been inverted at the state inversion encoding stage. In this example, the resulting group of data bits (on the lefthand side in FIG. 6) includes a number of ones reduced from 31 to 25 and the number of transitions reduced from 34 to 30.

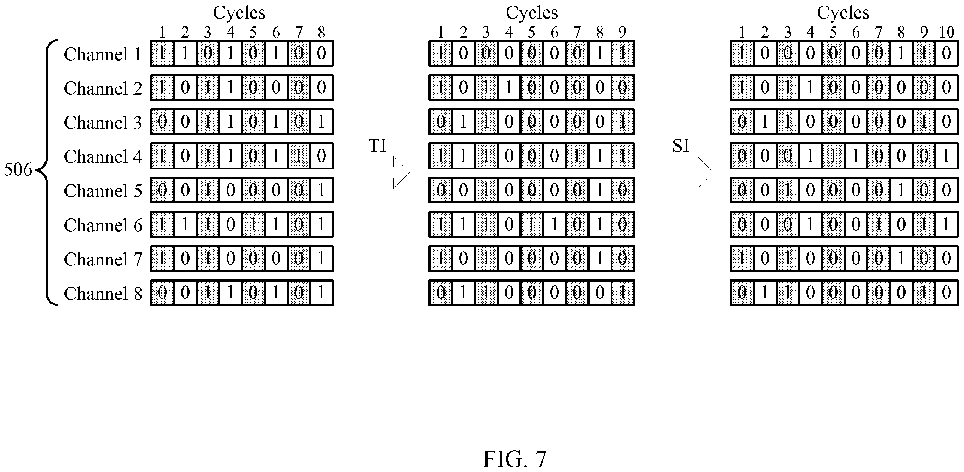

In the example in FIG. 6, two additional data bus channels are employed to transmit the TI and SI encoding flags, such that the group of data bits results in eight data cycles on ten channels. As noted above, the number of data cycles may vary as desired. In addition, other embodiments may use alternative means to transmit the encoding flags. For example, FIG. 7 illustrates another embodiment in which the DBI flags are transmitted on the original data channels as additional data bits appended to the end of the group of data bits. For example, a one or a zero is added as data bit 9 (or cycle 9) to indicate whether the channel has been inverted as part of the transition inversion encoding. As shown in FIG. 7, a one is sent in cycle 9 on channels 1, 3, 4, and 8 to indicate that every other bit has been inverted on these channels, and a zero is sent in cycle 9 on the other channels to indicate that every other bit has not been inverted on these channels. Another one or zero is also added as data bit or cycle 10 on each channel to indicate whether the channel has been inverted as part of state inversion encoding. In this example, the encoder 504 can take into account the TI encoding flag in cycle 9 for each channel. As shown in FIG. 7, a one is sent in cycle 10 on channels 4 and 6 to indicate that data bits 1 through 9 have been inverted on these two channels, and a zero is sent on cycle 10 on the other channels to indicate that data bits 1 through 9 have not been inverted on these channels. In this example, the group of data bits results in ten data cycles on eight data channels. Such examples can provide additional encoding by taking into account the TI encoding flag bits in cycle 9 when performing the state inversion encoding.

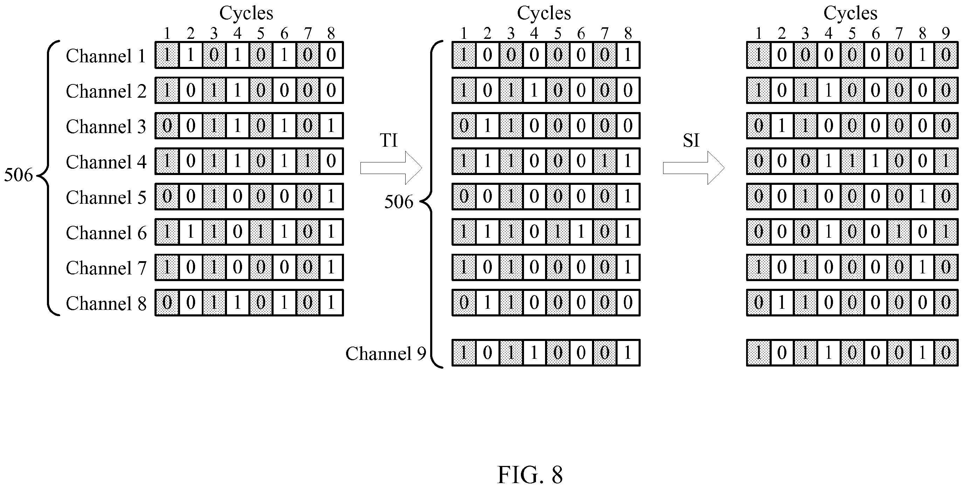

FIG. 8 is a block diagram illustrating yet another example in which one set of encoding flags are transmitted on an additional channel (channel 9) and the other set of encoding flags are transmitted as additional data bits appended to the end of the group of data bits. For example, a one or a zero is sent in a cycle on a new channel (channel 9) to indicate whether the channel corresponding to the cycle has been inverted as part of the transition inversion encoding. As shown in FIG. 8, a one is sent in cycles 1, 3, 4, and 8 on channel 9 to indicate that every other bit has been inverted on the corresponding channels 1, 3, 4, and 8, and a zero is sent in the other cycles on channel 9 to indicate that every other bit has not been inverted on the channels corresponding to those cycles. Further, a one or zero is added as data bit or cycle 9 on each of the channels, including channel 9, to indicate whether the channel has been inverted as part of state inversion encoding. As shown in FIG. 8, a one is sent in cycle 9 on channels 4 and 6 to indicate that data bits 1 through 8 have been inverted on these two channels, and a zero is sent on cycle 9 on the other channels to indicate that data bits 1 through 8 have not been inverted on these channels. In this example, the group of data bits is expanded to nine data cycles on nine data channels. Such examples can provide additional encoding by taking into account the TI encoding flag bits in channel 9 when performing the state inversion encoding, as well as only increasing the cycle size by one cycle.

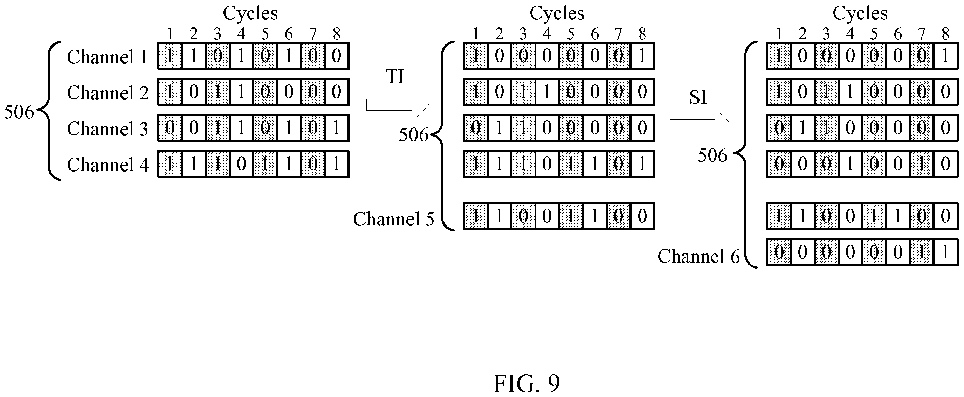

In some examples, it may occur that the number of data bits or cycles in the group of data bits is twice the size of the number of channels. For instance, FIG. 9 illustrates an example in which a group of data bits consists of eight cycles conveyed over four channels. In this example, instead of sending the encoding flags in the first or last four cycles and having unused cycles in the encoding flag channel, the encoder 504 can spread the flags over all eight cycles by associating two cycles with each channel. For example, transition inversion encoding is applied to the first and third channels (channel 1 and channel 3) in FIG. 9. As shown, the TI encoding flag for channel 1 is set by transmitting a one in both the first and second cycles on channel 5. Similarly, the TI encoding flag for channel 3 is set by transmitting a one in both the fifth and sixth cycles on channel 5. The encoding flags for state inversion encoding follow a similar configuration. For example, where channel 4 is inverted for state inversion encoding, the SI encoding flag is set by sending a one in cycles 7 and 8 on channel 6. Thus, the TI and SI encoding flags are adapted to extend two cycles for each channel.

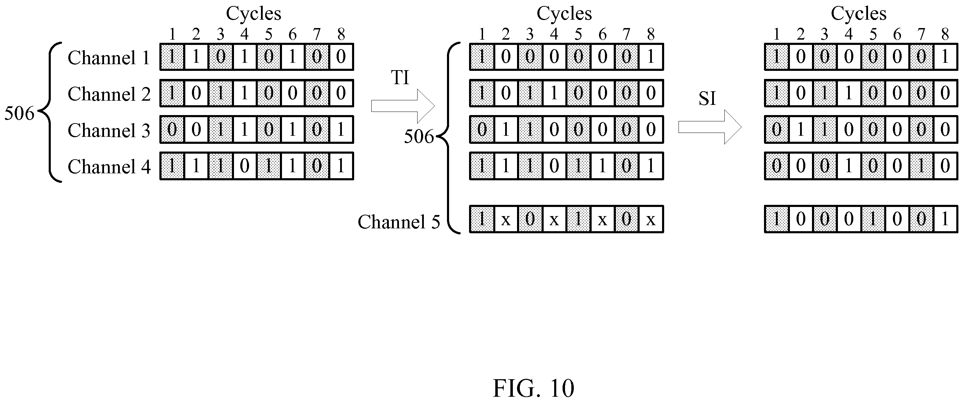

In another examples, depicted in FIG. 10, the group of data bits again consists of eight cycles conveyed over four channels. In this example, the encoder 504 can use a single additional channel for the TI and SI encoding flags, where two cycles in the added data channel are associated with each data channel. That is, like the example in FIG. 9, cycles 1 and 2 of channel 5 are associated with channel 1, cycles 3 and 4 are associated with channel 2, cycles 5 and 6 are associated with channel 3, and cycles 7 and 8 are associated with channel 4. In this example, however, the first cycles in channel 5 associated with each of the data channels can be used to indicate transition inversion encoding, and the second cycles in channel 5 associated with each of the data channels can be used to indicate state inversion encoding.

More specifically, the transition inversion encoding is applied to channel 1 and channel 3 in the depicted example. Accordingly, a one is placed in cycles 1 and 5 on channel 5 to indicate that transition inversion encoding has been applied to channels 1 and 3. Additionally, a zero is placed in cycles 3 and 7 to indicate that no inversion has been performed on channels 2 and 4 during transition inversion encoding. An 'x' is shown in cycles 2, 4, 6, and 8 on channel 5 to indicate that these cycles are irrelevant to the TI encoding flags. In the state inversion encoding step, channel 4 is inverted, while channels 1 through 3 are unchanged. Accordingly, a one is applied to cycle 8 on channel 5 to indicate that channel 4 has been inverted during state inversion encoding, and a zero is applied to cycles 2, 4, and 6 on channel 5 to indicate that channel 1, channel 2, and channel 3 have not been inverted during state inversion encoding. In this example, the encoding flags for both transition inversion encoding and state inversion encoding can be transmitted on a single added channel.

It is noteworthy that, although each of these examples depicts transition inversion encoding being performed first, followed by state inversion encoding performed on the transition inversion encoded data bits, these encoding steps can be switched so that the state inversion encoding is performed first and transition inversion encoding is performed on the data bits resulting from the state inversion encoding.

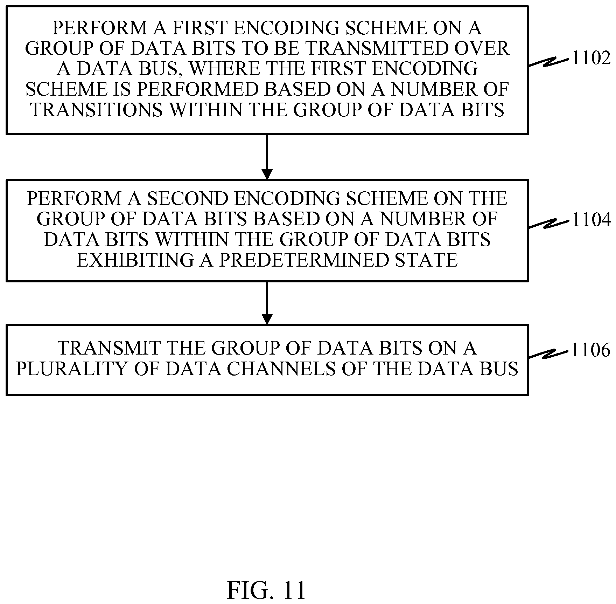

FIG. 11 is a flow diagram illustrating at least one example of a method operational on an electronic device, such as the electronic device 500 in FIG. 5. Referring to FIGS. 5 and 11, an electronic device 500 can perform a first encoding scheme on a group of data bits to be transmitted over a data bus, at block 1102. The first encoding scheme can be performed, in at least one example, based on a number of transitions within the group of data bits. For example, the processing circuit 510 of the encoder 504 may perform the first encoding scheme on the group of data bits based on the number of transitions within the group.

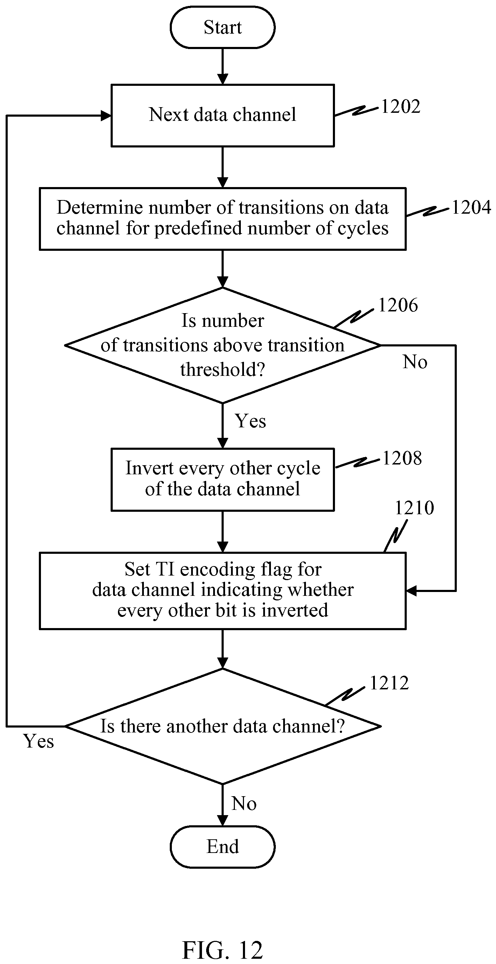

FIG. 12 is a flow diagram illustrating an example of a process for performing the first encoding scheme based on the number of transitions at block 1102 of FIG. 11 according to at least one implementation. In general, the processing circuit 510 of the encoder 504 can determine the number of transitions on each of a plurality of data channels of the data bus 506, and invert every other cycle on each data channel having a number of transitions above a transition threshold. For example, the process may begin by identifying a first data channel for the group of data bits at operation 1202. At operation 1204, the transition detector 514 executing the transition detection operations 520 can evaluate the data channel to determine the number of transitions on the data channel over a predefined number of cycles. As noted previously, the predefined number of cycles may vary according to the implementation. The examples described herein include implementations of eight cycles on each data channel, but other numbers of cycles may be employed.

At decision diamond 1206, the transition detector 514 executing the transition detection operations 520 can determine whether the number of transitions detected for the data channel is above a transition threshold. In at least one example, the transition threshold may be half the number of cycles evaluated at operation 1204. For instance, if the number of cycles evaluated on the data channel at operation 1204 is eight cycles, then the transition threshold may be four. Accordingly, if five or more transitions are detected at operation 1204, then the transition detector 514 executing the transition detection operations 520 can determine that the number of transitions is above the transition threshold at decision diamond 1206.

When the number of detected transitions over the predefined number of cycles is above the transition threshold, the invertor 518 executing the invert operations 524 can invert every other cycle of the data channel at operation 1208. That is, the invertor 518 executing the invert operations 524 can invert every other data bit over the predefined number of cycles in a manner similar to that described above with reference to FIG. 6 for the transition inversion encoding.

At operation 1210, the invertor 518 executing the invert operations 524 further sets a respective transition inversion (TI) encoding flag for the data channel to indicate whether or not every other cycle of the data channel has been inverted. For example, a one (or logic HIGH signal) may be set to indicate that every other cycle of the data channel has been inverted, and a zero (or logic LOW signal) may be set to indicate that every other cycle of the data channel has not been inverted, such as when the answer at decision diamond 1206 is no.

As described herein above with reference to FIGS. 6 through 10, the TI encoding flag may be set in various locations. For example, as described above with reference to FIGS. 6, 8, 9, and 10, the TI encoding flag may be set as data bits or cycles in an additional data channel (which may also be referred to as a flag channel). In some instances, such as in the examples described above with reference to FIGS. 6 and 8, each data bit or cycle of the additional data channel is associated with a respective data channel. In other instances, such as in the example described above with reference to FIG. 9, two or more consecutive cycles on the additional data channel are associated with a respective data channel. In still other instances, such as in the example described above with reference to FIG. 10, the TI encoding flags can be set on the same additional data channel that will be used to set the state inversion (SI) encoding flags. In other examples, as described above with reference to FIG. 7, the TI encoding flag may be set as an additional cycle appended to the respective data channel.

Referring still to FIG. 12, the transition detector 514 executing the transition detection operations 520 can determine whether there is another data channel to be evaluated for transitions at decision diamond 1212. If there is another data channel, the process can return to operation 1202 where the next data channel is selected for evaluation. If there are no more data channels, the process may be ended.

Referring back to FIGS. 5 and 11, the electronic device 500 can perform a second encoding scheme on the same group of data bits based on a number of data bits within the group of data bits exhibiting a predetermined state, at block 1104. For example, the processing circuit 510 of the encoder 504 may perform the second encoding scheme on the group of data bits based on the number of data bits within the group that are set to the predetermined state.

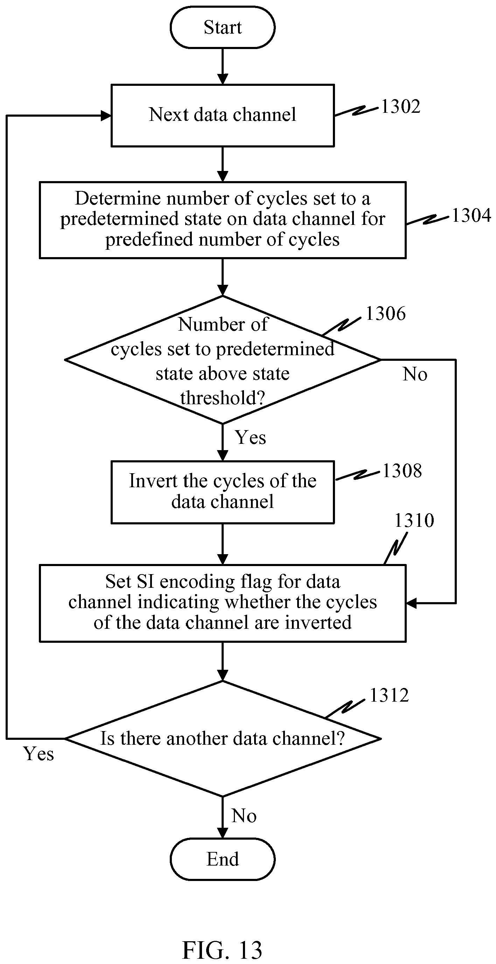

FIG. 13 is a flow diagram illustrating an example of a process for performing the second encoding scheme based on the number of cycles having a particular state at block 1104 of FIG. 11 according to at least one implementation. In general, the processing circuit 510 of the encoder 504 can determine the number of cycles set to a predetermined state on each of a plurality of data channels of the data bus 506, and invert the cycles on each data channel having a number of cycles set to the predetermined state above a state threshold. For example, the process may begin by identifying a first data channel at operation 1302. At operation 1304, the state detector 516 executing the state detection operations 522 can evaluate the data channel to determine the number of cycles set to the predetermined state (e.g., set to a one or a zero) on the data channel over the predefined number of cycles. In implementations where the first encoding scheme is performed before the second encoding scheme, the state detector 516 executing the state detection operations 522 will evaluate the data bits resulting from the first encoding scheme on the data channel.

At decision diamond 1306, the state detector 516 executing the state detection operations 522 can determine whether the number of cycles set to the predetermined state on the data channel is above a state threshold. In at least one example, the state threshold may be half the number of cycles evaluated at operation 1304. For instance, if the number of cycles evaluated on the data channel at operation 1304 is eight cycles, then the state threshold may be four. Accordingly, if five or more cycles are detected at operation 1304 to be set to the predetermined state, then the state detector 516 executing the state detection operations 522 can determine that the number of cycles set to the predetermined state is above the state threshold at decision diamond 1306.

When the number of data bits set to the predetermined state over the predefined number of cycles is above the state threshold, the invertor 518 executing the invert operations 524 can invert the cycles of the data channel at operation 1308. That is, the invertor 518 executing the invert operations 524 can invert the data bits over the predefined number of cycles in a manner similar to that described above with reference to FIG. 6 for the state inversion encoding.

At operation 1310, the invertor 518 executing the invert operations 524 further sets a respective state inversion (SI) encoding flag for the data channel to indicate whether or not the cycles of the data channel have been inverted. For example, a one (or logic HIGH signal) may be set to indicate that the cycles of the data channel have been inverted. Conversely, a zero (or logic LOW signal) may be set to indicate that the cycles of the data channel have not been inverted, such as when the answer at decision diamond 1306 is no.

As described herein above with reference to FIGS. 6 through 10, the SI encoding flag may be set in various locations according to different implementations. For example, as described above with reference to FIGS. 6, 9, and 10, the SI encoding flags may be set as data bits or cycles in an additional data channel (which may also be referred to as a flag channel). In some instances, such as in the example described above with reference to FIG. 6, each data bit or cycle of the additional data channel is associated with a respective data channel. In other instances, such as in the example described above with reference to FIG. 9, two or more consecutive cycles on the additional data channel are associated with a respective data channel. In still other instances, such as in the example described above with reference to FIG. 10, the SI encoding flags can be set on the same additional data channel that is used to set the transition inversion (TI) encoding flags. In other examples, as described above with reference to FIGS. 7 and 8, the SI encoding flag may be set as an additional cycle appended to the respective data channel.

Referring still to FIG. 13, the state detector 516 executing the state detection operations 522 can determine whether there is another data channel to be evaluated for transitions at decision diamond 1312. If there is another data channel, the process can return to operation 1302 where the next data channel is selected for evaluation. If there are no more data channels, the process may be ended.

Referring again to FIGS. 5 and 11, the electronic device 500 can transmit the group of encoded data bits on a plurality of data channels of the data bus, at block 1106. For example, the processing circuit 510 of the encoder 504 may transmit each channel of the encoded data bits on at least some of the data channels of the data bus, via the data bus interface 508.

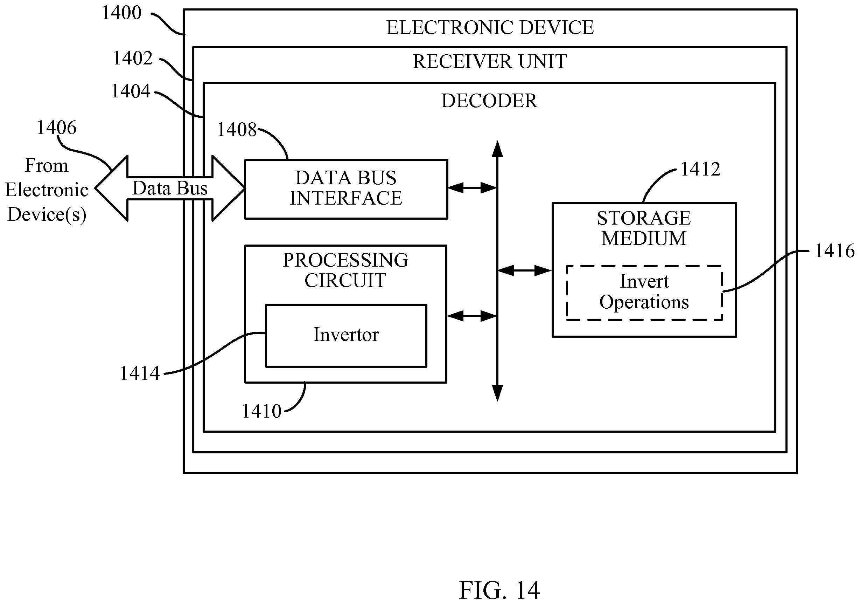

Turning to FIG. 14, a block diagram is shown illustrating select components of an electronic device 1400, such as the first or second electronic device 102, 104 from FIG. 1, according to at least one example of the present disclosure. A receiver unit 1402 of the electronic device 1400 includes a decoder 1404 adapted to receive encoded data bits transmitted over a plurality of channels of a data bus 1406.

The decoder 1404 generally includes circuitry and/or programming adapted to decode a first encoding scheme for a plurality of data bits and a second encoding scheme for the same plurality of data bits. That is, the decoder is adapted to undo the encoding performed by an encoder, such as the encoder 504 and any of the encoding schemes described above. According to at least one example, the decoder 1404 may be coupled to a plurality of data channels of the data bus 1406 by a data bus interface 1408, and may include a processing circuit 1410 coupled to or placed in electrical communication with the data bus interface 1408 and a storage medium 1412.

The processing circuit 1410 is arranged to obtain, process and/or send data, control data access and storage, issue commands, and control other desired operations. The processing circuit 1410 may include circuitry configured to perform a desired function and/or implement desired programming provided by appropriate media. The processing circuit 1410 may be implemented and/or configured according to any of the examples of the processing circuit 510 described above.

The processing circuit 1410 may include an invertor 1414. The invertor 1414 may include circuitry and/or programming (e.g., the invert operations 1416 stored on the storage medium 1412) adapted to invert received data bits back to their original state according to state encoding flags and transition encoding flags included with the received data bits.

The storage medium 1412 may represent one or more processor-readable devices for storing programming, such as processor executable code or instructions (e.g., software, firmware), electronic data, databases, or other digital information. The storage medium 1412 may be configured and/or implemented in a manner similar to the storage medium 512 described above.

The storage medium 1412 may be coupled to the processing circuit 1410 such that the processing circuit 1410 can read information from, and write information to, the storage medium 1412. That is, the storage medium 1412 can be coupled to the processing circuit 1410 so that the storage medium 1412 is at least accessible by the processing circuit 1410, including examples where the storage medium 1412 is integral to the processing circuit 1410 and/or examples where the storage medium 1412 is separate from the processing circuit 1410.

Like the storage medium 512, the storage medium 1412 includes programming stored thereon. The programming stored by the storage medium 1412, when executed by the processing circuit 1414, causes the processing circuit 1414 to perform one or more of the various decoding functions and/or process steps described herein. For example, the storage medium 1412 may include invert operations 1416 adapted to cause the processing circuit 1412 to invert received data bits back to their original state according to the various encoding flags included with the received data. Thus, according to one or more aspects of the present disclosure, the processing circuit 1410 is adapted to perform (in conjunction with the storage medium 1412) any or all of the decoding processes, functions, steps and/or routines for any or all of the electronic devices described herein (e.g., electronic devices 102, 104, and 1400). As used herein, the term "adapted" in relation to the processing circuit 1410 may refer to the processing circuit 1410 being one or more of configured, employed, implemented, and/or programmed (in conjunction with the storage medium 1412) to perform a particular process, function, step and/or routine according to various features described herein.

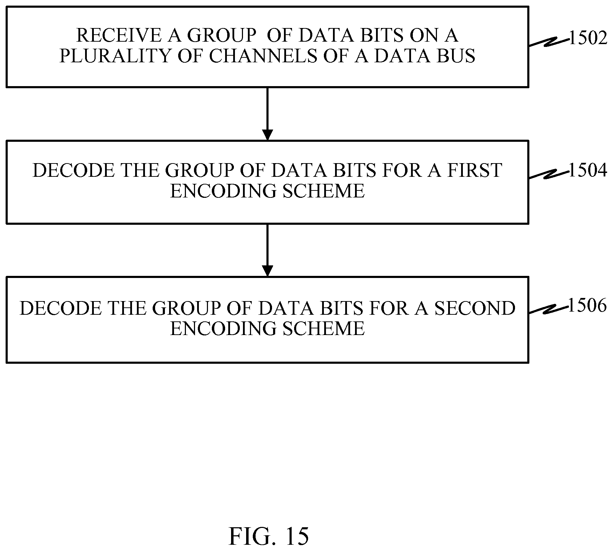

FIG. 15 is a flow diagram illustrating at least one example of a decoding method operational on an electronic device, such as the electronic device 1400. Referring to FIGS. 14 and 15, an electronic device 1400 may receive a group of data bits on a plurality of data channels of a data bus at 1502. For example, the processing circuit 1410 (e.g., the invertor 1414) executing the invert operations 1416 may receive a predetermined number of data bits over a plurality of data channels of the data bus 1406 via the data bus interface 1408. The group of data bits includes encoded data bits as well as a plurality of encoding flags. For instance, in the examples described above with reference to FIGS. 6 through 10, the electronic device 1400 can receive an encoded group of data bits like those set forth on the far right sides of each respective figure.

At 1504, the electronic device 1400 can decode the group of data bits for a first encoding scheme. For example, the processing circuit 1410 (e.g., the invertor 1414) executing the invert operations 1416 can identify the encoding flags associated with the last employed encoding scheme. Referring to the examples described hereinabove with reference to FIGS. 6 through 10, the processing circuit 1410 (e.g., the invertor 1414) executing the invert operations 1416 can identify the state inversion (SI) encoding flags associated with each data channel. As noted above, the SI encoding flags may be included in an additional channel or in an additional cycle on each channel. For each channel indicated by the SI encoding flags to have been inverted, the processing circuit 1410 (e.g., the invertor 1414) executing the invert operations 1416 can invert the data bits. Thus, for instance, in FIG. 6, data channel 10 indicates that data channels 4 and 6 have been inverted. Accordingly, the processing circuit 1410 (e.g., the invertor 1414) executing the invert operations 1416 can invert the received group of data bits from the far right-side to obtain the group of data bits shown in the middle for each of the channels.

At 1506, the electronic device 1400 can decode the group of data bits for a second encoding scheme. For example, the processing circuit 1410 (e.g., the invertor 1414) executing the invert operations 1416 can identify the encoding flags associated with the first employed encoding scheme. Referring to the examples described above with reference to FIGS. 6 through 10, the processing circuit 1410 (e.g., the invertor 1414) executing the invert operations 1416 can identify the transition inversion (TI) encoding flags associated with each data channel. As noted above, the TI encoding flags may be included in an additional channel or in an additional cycle on each channel. For each channel indicated by the TI encoding flags to have been inverted, the processing circuit 1410 (e.g., the invertor 1414) executing the invert operations 1416 can invert every other data bit back to its original state. Thus, continuing with the example in FIG. 6, data channel 9 indicates that the data channels 1, 3, 4, and 8 were all encoded by inverting every other data bit on each of those channels. Accordingly, the processing circuit 1410 (e.g., the invertor 1414) executing the invert operations 1416 can invert every other data bit in the partially decoded data shown in the middle in FIG. 6 to obtain the group of data bits shown on the left side of FIG. 6, which represents the original data bits.

Those of skill in the art will recognize that the order of decoding will directly depend on the order in which the original group of data bits was encoded. Thus, if the original group of data bits was encoded by state inversion encoding followed by transition inversion encoding, then the decoder 1404 can decode the received data bits by performing a decode for transition inversion encoding followed by a decode for state inversion encoding.

While the above discussed aspects, arrangements, and embodiments are discussed with specific details and particularity, one or more of the components, steps, features and/or functions illustrated in FIGS. 1, 2, 3, 4, 5, 6, 7, 8, 9, 10, 11, 12, 13, 14, and/or 15 may be rearranged and/or combined into a single component, step, feature or function or embodied in several components, steps, or functions. Additional elements, components, steps, and/or functions may also be added or not utilized without departing from the present disclosure. The apparatus, devices and/or components illustrated in FIGS. 1, 5, and/or 14 may be configured to perform or employ one or more of the methods, features, parameters, and/or steps described in FIGS. 2, 3, 4, 6, 7, 8, 9, 10, 11, 12, 13, and/or 15. The novel algorithms described herein may also be efficiently implemented in software and/or embedded in hardware.

While features of the present disclosure may have been discussed relative to certain embodiments and figures, all embodiments of the present disclosure can include one or more of the advantageous features discussed herein. In other words, while one or more embodiments may have been discussed as having certain advantageous features, one or more of such features may also be used in accordance with any of the various embodiments discussed herein. In similar fashion, while exemplary embodiments may have been discussed herein as device, system, or method embodiments, it should be understood that such exemplary embodiments can be implemented in various devices, systems, and methods.

Also, it is noted that at least some implementations have been described as a process that is depicted as a flowchart, a flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed. A process may correspond to a method, a function, a procedure, a subroutine, a subprogram, etc. When a process corresponds to a function, its termination corresponds to a return of the function to the calling function or the main function. The various methods described herein may be partially or fully implemented by programming (e.g., instructions and/or data) that may be stored in a machine-readable, computer-readable, and/or processor-readable storage medium, and executed by one or more processors, machines and/or devices.

Those of skill in the art would further appreciate that the various illustrative logical blocks, modules, circuits, and algorithm steps described in connection with the embodiments disclosed herein may be implemented as hardware, software, firmware, middleware, microcode, or any combination thereof. To clearly illustrate this interchangeability, various illustrative components, blocks, modules, circuits, and steps have been described above generally in terms of their functionality. Whether such functionality is implemented as hardware or software depends upon the particular application and design constraints imposed on the overall system.

The various features associate with the examples described herein and shown in the accompanying drawings can be implemented in different examples and implementations without departing from the scope of the present disclosure. Therefore, although certain specific constructions and arrangements have been described and shown in the accompanying drawings, such embodiments are merely illustrative and not restrictive of the scope of the disclosure, since various other additions and modifications to, and deletions from, the described embodiments will be apparent to one of ordinary skill in the art. Thus, the scope of the disclosure is only determined by the literal language, and legal equivalents, of the claims which follow.

## Claims

1. An electronic device (500) comprising at least one encoder (514), the encoder comprising:
a data bus interface (508) adapted to be coupled with a data bus (506) to facilitate a transmission of data bits; and
a processing circuit (510) coupled with the data bus interface, the processing circuit adapted to:
perform, on each channel of a plurality of data channels on the data bus, a first encoding scheme (TI) on a group of data bits to be transmitted on a data bus via the data bus interface to generate a first group of encoded data bits, wherein the first encoding scheme is performed based on a number of transitions within the group of data bits; and
perform, on each channel of the plurality of data channels on the data bus, a second encoding scheme (SI) on the first group of encoded data bits based on a number of data bits within the first group of encoded data bits exhibiting a predetermined state to generate a second group of encoded data bits.

2. The electronic device of claim 1, wherein the processing circuit is further adapted to:
set a plurality of first encoding flags to indicate which data bits are encoded by the first encoding scheme; and
set a plurality of second encoding flags to indicate which data bits are encoded by the second encoding scheme, wherein the first encoding flags are either set as
data bits in an additional data channel, wherein each data bit of the additional data channel is associated with a respective data channel of the group of data bits, or
data bits added to each respective data channel, wherein the second encoding flags are either set as
data bits in an additional data channel, wherein each data bit of the additional data channel is associated with a respective data channel of the group of data bits, or
data bits added to each respective data channel.

3. A method operational on an electronic device (500), comprising:
performing, on each channel of a plurality of data channels on a data bus (506), a first encoding scheme (TI) on a group of data bits to be transmitted over the data bus to generate a first group of encoded data bits, wherein the first encoding scheme is performed based on a number of transitions within the group of data bits; and
performing, on each channel of the plurality of data channels on the data bus, a second encoding scheme (SI) on the first group of encoded data bits based on a number of data bits within the first group of encoded data bits exhibiting a predetermined state to generate a second group of encoded data bits.

4. The method of claim 3, wherein performing the first encoding scheme on the group of data bits comprises:
determining a number of transitions on each data channel of a plurality of data channels on the data bus over a duration of a predetermined number of data bits; and
inverting every other data bit of the predetermined number of data bits on a data channel when the number of transitions on the data channel is determined to be above a transition threshold.

5. The method of claim 3, wherein performing the second encoding scheme on the first group of encoded data bits comprises:
determining a number of data bits set to a predetermined state on each data channel of a plurality of data channels on the data bus over a duration of a predetermined number of data bits; and
inverting the data bits of the predetermined number of data bits on a data channel when the number of data bits set to the predetermined state on the data channel is above a state threshold.

6. The method of claim 3, further comprising:
setting first encoding flags to indicate which data bits are encoded by the first encoding scheme; and
setting second encoding flags to indicate which data bits are encoded by the second encoding scheme.

7. The method of claim 6, wherein setting the first encoding flags comprises:
setting data bits in an additional data channel, wherein each data bit of the additional data channel is associated with a respective data channel of the group of data bits, or
setting data bits added to each respective data channel.

8. The method of claim 6, wherein setting the second encoding flags comprises:
setting data bits in an additional data channel, wherein each data bit of the additional data channel is associated with a respective data channel of the group of data bits, or
setting data bits added to each respective data channel.

9. An electronic device (1400) comprising at least one decoder (1404), the decoder comprising:
a data bus (1408) interface adapted to be coupled with a data bus (1406) to facilitate a reception of data bits; and
an invertor (1414) coupled with the data bus interface, the invertor adapted to:
receive, via the data bus interface, a group of data bits on a plurality of data channels;
decode the group of data bits for a first encoding scheme (TI) to generate a first group of decoded data bits; and
decode the first group of decoded data bits for a second encoding scheme (SI) to generate a second group of decoded data bits; where the first and second encoding schemes are according to claim 1.

10. The electronic device of claim 9, wherein the invertor adapted to decode the group of data bits for the first encoding scheme comprises the invertor adapted to:
identify encoding flags associated with the first encoding scheme; and
invert data bits indicated by the encoding flags associated with the first encoding scheme to have been inverted, wherein the invertor adapted to decode the first group of decoded data bits for the second encoding scheme comprises the invertor adapted to:
identify encoding flags associated with the second encoding scheme; and
invert data bits indicated by the encoding flags associated with the second encoding scheme to have been inverted.

11. A method operational on an electronic device (500), comprising:
receiving a group of data bits on a plurality of data channels of a data bus (506);
decoding the group of data bits for a first encoding scheme (TI) to generate a first group of decoded data bits; and
decoding the first group of decoded data bits for a second encoding scheme (SI) to generate a second group of decoded data bits; where the first and second encoding schemes are according to claim 1.

12. The method of claim 11, wherein decoding the group of data bits for a first encoding scheme comprises:
identifying encoding flags associated with the first encoding scheme; and
inverting data bits indicated by the encoding flags associated with the first encoding scheme to have been inverted.

13. The method of claim 11, wherein decoding the first group of decoded data bits for a second encoding scheme comprises:
identifying encoding flags associated with the second encoding scheme; and
inverting data bits indicated by the encoding flags associated with the second encoding scheme to have been inverted.

14. The method of claim 11, wherein decoding the group of data bits for a first encoding scheme comprises:
decoding the group of data bits for an encoding scheme based on a number of data bits on a data channel exhibiting a predetermined state.

15. The method of claim 11, wherein decoding the group of data bits for a first encoding scheme comprises:
decoding the group of data bits for an encoding scheme based on a number of transitions on a data channel.

## Patentansprüche

1. Eine Elektronikeinrichtung (500), die wenigstens einen Codierer (514) aufweist, wobei der Codierer Folgendes aufweist:
eine Datenbusschnittstelle (508), die ausgelegt ist, mit einem Datenbus (506) gekoppelt zu werden um eine Sendung von Datenbits zu ermöglichen; und
eine Verarbeitungsschaltung (510), die mit der Datenbusschnittstelle gekoppelt ist, wobei die Verarbeitungsschaltung ausgelegt ist zum:
Durchführen, auf jedem Kanal einer Vielzahl von Datenkanälen auf dem Datenbus, eines ersten Codierschemas (TI) an einer Gruppe von Datenbits, die auf einem Datenbus über die Datenbusschnittstelle gesendet werden sollen zum Generieren einer ersten Gruppe von codierten Datenbits, wobei das erste Codierschema durchgeführt wird basierend auf einer Anzahl von Übergängen innerhalb der Gruppe von Datenbits; und
Durchführen, auf jedem Kanal der Vielzahl von Datenkanälen auf dem Datenbus, eines zweiten Codierschemas (SI) an der ersten Gruppe von codierten Datenbits basierend auf einer Anzahl von Datenbits innerhalb der ersten Gruppe von codierten Datenbits, die einen vorbestimmten Zustand zeigen, zum Generieren einer zweiten Gruppe von codierten Datenbits.

2. Elektronikeinrichtung nach Anspruch 1, wobei die Verarbeitungsschaltung weiter ausgelegt ist zum:
Setzen einer Vielzahl von ersten Codier-Flags um anzuzeigen, welche Datenbits durch das erste Codierschema codiert sind; und
Setzen einer Vielzahl von zweiten Codier-Flags um anzuzeigen, welche Datenbits durch das zweite Codierschema codiert sind, wobei die ersten Codier-Flags entweder gesetzt werden als
Datenbits in einem zusätzlichen Datenkanal, wobei jedes Datenbit des zusätzlichen Datenkanals mit einem entsprechenden Datenkanal der Gruppe von Datenbits assoziiert ist, oder
Datenbits, die jedem entsprechenden Datenkanal hinzugefügt werden, wobei die zweiten Codier-Flags entweder gesetzt werden als
Datenbits in einem zusätzlichen Datenkanal, wobei jedes Datenbit des zusätzlichen Datenkanals mit einem entsprechenden Datenkanal der Gruppe von Datenbits assoziiert ist, oder
Datenbits, die jedem entsprechenden Datenkanal hinzugefügt werden.

3. Ein Verfahren, das auf einer Elektronikeinrichtung (500) betreibbar ist, das Folgendes aufweist:
Durchführen, auf jedem Kanal einer Vielzahl von Datenkanälen auf einem Datenbus (506), eines ersten Codierschemas (TI) an einer Gruppe von Datenbits, die über den Datenbus gesendet werden sollen zum Generieren einer ersten Gruppe von codierten Datenbits, wobei das erste Codierschema basierend auf einer Anzahl von Übergängen innerhalb der Gruppe von Datenbits durchgeführt wird; und
Durchführen, auf jedem Kanal einer Vielzahl von Datenkanälen auf dem Datenbus, eines zweiten Codierschemas (SI) an der ersten Gruppe von codierten Datenbits basierend auf einer Anzahl von Datenbits innerhalb der ersten Gruppe von codierten Datenbits, die einen vorbestimmten Zustand zeigen, zum Generieren einer zweiten Gruppe von codierten Datenbits.

4. Verfahren nach Anspruch 3, wobei das Durchführen des ersten Codierschemas an der Gruppe von Datenbits Folgendes aufweist:
Bestimmen einer Anzahl von Übergängen auf jedem Datenkanal einer Vielzahl von Datenkanälen auf dem Datenbus über eine Dauer einer vorbestimmten Anzahl von Datenbits; und
Invertieren jedes zweiten Datenbits der vorbestimmten Anzahl von Datenbits auf einem Datenkanal, wenn bestimmt wird, dass die Anzahl von Übergängen auf dem Datenkanal über einem Übergangsschwellenwert ist.

5. Verfahren nach Anspruch 3, wobei das Durchführen des zweiten Codierschemas an der ersten Gruppe von codierten Datenbits Folgendes aufweist:
Bestimmen einer Anzahl von Datenbits, die auf einen bestimmten Zustand gesetzt sind, auf jedem Datenkanal einer Vielzahl von Datenkanälen auf dem Datenbus über eine Dauer einer vorbestimmten Anzahl von Datenbits; und
Invertieren der Datenbits der vorbestimmten Anzahl von Datenbits auf einem Datenkanal, wenn die Anzahl von Datenbits, die auf den vorbestimmten Zustand auf dem Datenkanal gesetzt ist, über einem Zustandsschwellenwert ist.

6. Verfahren nach Anspruch 3, das weiter Folgendes aufweist:
Setzen erster Codier-Flags um anzuzeigen, welche Datenbits durch das erste Codierschema codiert sind; und
Setzen zweiter Codier-Flags, um anzuzeigen, welche Datenbits durch das zweite Codierschema codiert sind.

7. Verfahren nach Anspruch 6, wobei das Setzen der ersten Codier-Flags Folgendes aufweist:
Setzen von Datenbits in einem zusätzlichen Datenkanal, wobei jedes Datenbit des zusätzlichen Datenkanals mit einem jeweiligen Datenkanal der Gruppe von Datenbits assoziiert ist, oder
Setzen von Datenbits, die jedem entsprechenden Datenkanal hinzugefügt sind.

8. Verfahren nach Anspruch 6, wobei das Setzen der zweiten Codier-Flags Folgendes aufweist:
Setzen von Datenbits in einem zusätzlichen Datenkanal, wobei jedes Datenbit des zusätzlichen Datenkanals mit einem entsprechenden Datenkanal der Gruppe von Datenbits assoziiert ist, oder
Setzen von Datenbits, die jedem entsprechenden Datenkanal hinzugefügt sind.

9. Eine Elektronikeinrichtung (1400), die wenigstens einen Decodierer (1404) aufweist, wobei der Decodierer Folgendes aufweist:
eine Datenbusschnittstelle (1408), die ausgelegt ist mit einem Datenbus (1406) gekoppelt zu werden zum Ermöglichen eines Empfangs von Datenbits; und
einen Inverter (1414), der mit der Datenbusschnittstelle gekoppelt ist, wobei der Inverter ausgelegt ist zum:
Empfangen, über die Datenbusschnittstelle, einer Gruppe von Datenbits auf einer Vielzahl von Datenkanälen;
Decodieren der Gruppe von Datenbits für ein erstes Codierschema (TI) zum Generieren einer ersten Gruppe von decodierten Datenbits; und
Decodieren der ersten Gruppe von decodierten Datenbits für ein zweites Codierschema (SI) zum Generieren einer zweiten Gruppe von decodierten Datenbits;
wobei die ersten und zweiten Codierschemata gemäß Anspruch 1 sind.

10. Elektronikeinrichtung nach Anspruch 9, wobei der Inverter, der ausgelegt ist zum Decodieren der Gruppe von Datenbits für das erste Codierschema, den Inverter aufweist, der ausgelegt ist zum:
Identifizieren von Codier-Flags, die mit dem ersten Codierschema assoziiert sind; und
Invertieren von Datenbits, bezüglich denen durch die Codier-Flags, die mit dem ersten Codierschema assoziiert sind, angezeigt wird, dass sie invertiert worden sind, wobei der Inverter, der ausgelegt ist zum Decodieren der ersten Gruppe von decodierten Datenbits für das zweite Codierschema, den Inverter aufweist, der ausgelegt ist zum:
Identifizieren von Codier-Flags, die mit dem zweiten Codierschema assoziiert sind; und
Invertieren von Datenbits, bezüglich denen durch die Codier-Flags, die mit dem zweiten Codierschema assoziiert sind, angezeigt wird, dass sie invertiert worden sind.

11. Ein Verfahren, das auf einer Elektronikeinrichtung (500) betreibbar ist, das Folgendes aufweist:
Empfangen einer Gruppe von Datenbits auf einer Vielzahl von Datenkanälen eines Datenbusses (506);
Decodieren der Gruppe von Datenbits für ein erstes Codierschema (TI) zum Generieren einer ersten Gruppe von decodierten Datenbits; und
Decodieren der ersten Gruppe von decodierten Datenbits für ein zweites Codierschema (SI) zum Generieren einer zweiten Gruppe von decodierten Datenbits;
wobei die ersten und zweiten Codierschemata gemäß Anspruch 1 sind.

12. Verfahren nach Anspruch 11, wobei das Decodieren der Gruppe von Datenbits für ein erstes Codierschema Folgendes aufweist:
Identifizieren von Codier-Flags, die mit dem ersten Codierschema assoziiert sind; und
Invertieren von Datenbits, bezüglich denen durch die Codier-Flags, die mit dem ersten Codierschema assoziiert sind, angezeigt wird, dass sie invertiert worden sind.

13. Verfahren nach Anspruch 11, wobei das Decodieren der ersten Gruppe von decodierten Datenbits für ein zweites Codierschema Folgendes aufweist:
Identifizieren von Codier-Flags, die mit dem zweiten Codierschema assoziiert sind; und
Invertieren von Datenbits, bezüglich denen durch die Codier-Flags, die mit dem zweiten Codierschema assoziiert sind, angezeigt wird, dass sie invertiert worden sind.

14. Verfahren nach Anspruch 11, wobei das Decodieren der Gruppe von Datenbits für ein erstes Codierschema Folgendes aufweist:
Decodieren der Gruppe von Datenbits für ein Codierschema basierend auf einer Anzahl von Datenbits auf einem Datenkanal, die einen vorbestimmten Zustand zeigen.

15. Verfahren nach Anspruch 11, wobei das Decodieren der Gruppe von Datenbits für ein erstes Codierschema Folgendes aufweist:
Decodieren der Gruppe von Datenbits für ein Codierschema basierend auf einer Anzahl von Übergängen auf einem Datenkanal.

## Revendications

1. Dispositif électronique (500) comprenant au moins un codeur (514), le codeur comprenant :
une interface de bus de données (508) adaptée à être couplée à un bus de données (506) afin de faciliter une transmission de bits de données ; et
un circuit de traitement (510) couplé à l'interface de bus de données, le circuit de traitement étant adapté à :
mettre en oeuvre, sur chaque canal d'une pluralité de canaux de données sur le bus de données, un premier schéma de codage (TI) sur un groupe de bits de données à transmettre sur un bus de données via l'interface de bus de données, pour générer un premier groupe de bits de données codés, le premier schéma de codage étant exécuté sur la base d'un nombre de transitions dans le groupe de bits de données ; et
mettre en oeuvre, sur chaque canal de la pluralité de canaux de données sur le bus de données, un deuxième schéma de codage (SI) sur le premier groupe de bits de données codés sur la base d'un nombre de bits de données dans le premier groupe de bits de données codés présentant un état prédéterminé, pour générer un deuxième groupe de bits de données codés.

2. Dispositif électronique selon la revendication 1, dans lequel le circuit de traitement est en outre adapté à :
établir une pluralité de premiers drapeaux de codage pour indiquer quels bits de données sont codés par le premier schéma de codage ; et
établir une pluralité de deuxièmes drapeaux de codage pour indiquer quels bits de données sont codés par le deuxième schéma de codage, les premiers drapeaux de codage étant définis en tant que
bits de données dans un canal de données supplémentaire, chaque bit de données du canal de données supplémentaire étant associé à un canal de données respectif du groupe de bits de données, ou
bits de données ajoutés à chaque canal de données respectif, les deuxièmes drapeaux de codage étant définis en tant que
bits de données dans un canal de données supplémentaire, chaque bit de données du canal de données supplémentaire étant associé à un canal de données respectif du groupe de bits de données, ou
bits de données ajoutés à chaque canal de données respectif.

3. Procédé opérationnel sur un dispositif électronique (500) comprenant :
la mise en oeuvre, sur chaque canal d'une pluralité de canaux de données sur un bus de données (506), d'un premier schéma de codage (TI) sur un groupe de bits de données à transmettre sur le bus de données pour générer un premier groupe de bits de données codés, le premier schéma de codage étant exécuté sur la base d'un nombre de transitions dans le groupe de bits de données ; et
la mise en oeuvre, sur chaque canal de la pluralité de canaux de données sur le bus de données, d'un deuxième schéma de codage (SI) sur le premier groupe de bits de données codés sur la base d'un nombre de bits de données dans le premier groupe de bits de données codés présentant un état prédéterminé, pour générer un deuxième groupe de bits de données codés.

4. Procédé selon la revendication 3, dans lequel la mise en oeuvre du premier schéma de codage sur le groupe de bits de données comprend :
la détermination d'un nombre de transitions sur chaque canal de données d'une pluralité de canaux de données sur le bus de données pendant une durée d'un nombre prédéterminé de bits de données ; et
l'inversion de chaque autre bit de données du nombre prédéterminé de bits de données sur un canal de données lorsque le nombre de transitions sur le canal de données est déterminé comme étant supérieur à un seuil de transition.

5. Procédé selon la revendication 3, dans lequel la mise en oeuvre du deuxième schéma de codage sur le premier groupe de bits de données codés comprend :
la détermination d'un nombre de bits de données mis dans un état prédéterminé sur chaque canal de données d'une pluralité de canaux de données sur le bus de données pendant une durée d'un nombre prédéterminé de bits de données ; et
l'inversion des bits de données du nombre prédéterminé de bits de données sur un canal de données lorsque le nombre de bits de données mis dans l'état prédéterminé sur le canal de données est supérieur à un seuil d'état.

6. Procédé selon la revendication 3, comprenant en outre :
l'établissement de premiers drapeaux de codage pour indiquer quels bits de données sont codés par le premier schéma de codage ; et
l'établissement de deuxièmes drapeaux de codage pour indiquer quels bits de données sont codés par le deuxième schéma de codage.

7. Procédé selon la revendication 6, dans lequel l'établissement des premiers drapeaux de codage comprend :
l'établissement de bits de données dans un canal de données supplémentaire, chaque bit de données du canal de données supplémentaire étant associé à un canal de données respectif du groupe de bits de données, ou
l'établissement de bits de données ajoutés à chaque canal de données respectif.

8. Procédé selon la revendication 6, dans lequel l'établissement des deuxièmes drapeaux de codage comprend :
l'établissement de bits de données dans un canal de données supplémentaire, chaque bit de données du canal de données supplémentaire étant associé à un canal de données respectif du groupe de bits de données, ou
l'établissement de bits de données ajoutés à chaque canal de données respectif.

9. Dispositif électronique (1400) comprenant au moins un décodeur (1404), le décodeur comprenant :
une interface de bus de données (1408) adaptée à être couplée à un bus de données (1406) afin de faciliter une réception de bits de données ; et
un inverseur (1414) couplé à l'interface de bus de données, l'inverseur étant adapté à :
recevoir, via l'interface de bus de données, un groupe de bits de données sur une pluralité de canaux de données ;
décoder le groupe de bits de données pour un premier schéma de codage (TI) pour générer un premier groupe de bits de données décodés ; et
décoder le premier groupe de bits de données décodés pour un deuxième schéma de codage (SI) pour générer un deuxième groupe de bits de données décodés ; les premier et deuxième schémas de codage étant conformes à la revendication 1.

10. Dispositif électronique selon la revendication 9, dans lequel l'inverseur adapté à décoder le groupe de bits de données pour le premier schéma de codage comprend l'inverseur adapté à :
identifier des drapeaux de codage associés au premier schéma de codage ; et
inverser des bits de données indiqués par les drapeaux de codage associés au premier schéma de codage comme ayant été inversés, l'inverseur adapté à décoder le premier groupe de bits de données décodés pour le deuxième schéma de codage comprenant l'inverseur adapté à :
identifier des drapeaux de codage associés au deuxième schéma de codage ; et
inverser des bits de données indiqués par les drapeaux de codage associés au deuxième schéma de codage comme ayant été inversés.

11. Procédé opérationnel sur un dispositif électronique (500) comprenant :
la réception d'un groupe de bits de données sur une pluralité de canaux de données d'un bus de données (506) ;
le décodage du groupe de bits de données pour un premier schéma de codage (TI) pour générer un premier groupe de bits de données décodés ; et
le décodage du premier groupe de bits de données décodés pour un deuxième schéma de codage (SI) pour générer un deuxième groupe de bits de données décodés ; les premier et deuxième schémas de codage étant conformes à la revendication 1.

12. Procédé selon la revendication 11, dans lequel le décodage du groupe de bits de données pour un premier schéma de codage comprend :
l'identification de drapeaux de codage associés au premier schéma de codage ; et
l'inversion de bits de données indiqués par les drapeaux de codage associés au premier schéma de codage comme ayant été inversés.

13. Procédé selon la revendication 11, dans lequel le décodage du groupe de bits de données décodés pour un deuxième schéma de codage comprend :
l'identification de drapeaux de codage associés au deuxième schéma de codage ; et
l'inversion de bits de données indiqués par les drapeaux de codage associés au deuxième schéma de codage comme ayant été inversés.

14. Procédé selon la revendication 11, dans lequel le décodage du groupe de bits de données pour un premier schéma de codage comprend :
le décodage du groupe de bits de données pour un schéma de codage basé sur un nombre de bits de données sur un canal de données présentant un état prédéterminé.

15. Procédé selon la revendication 11, dans lequel le décodage du groupe de bits de données pour un premier schéma de codage comprend :
le décodage du groupe de bits de données pour un schéma de codage sur la base d'un nombre de transitions sur un canal de données.
